# Europäisches Patentamt

# European Patent Office

# Office européen des brevets

(19)

(11) Veröffentlichungsnummer : **0 448 614 B1**

(12) **EUROPÄISCHE PATENTSCHRIFT**

(45) Veröffentlichungstag der Patentschrift :
09.06.93 Patentblatt 93/23

(51) Int. Cl.⁵ : **B41J 2/05, B41J 2/145**

(21) Anmeldenummer : 90900866.6

(22) Anmeldetag : 12.12.89

(86) Internationale Anmeldenummer :
PCT/EP89/01526

(87) Internationale Veröffentlichungsnummer :
WO 90/06853 28.06.90 Gazette 90/15

(54) **VERFAHREN ZUR OPTIMIERUNG EINER LEITERBAHNANORDNUNG FÜR EINEN SCHREIBKOPF IN TINTENDRUCKEINRICHTUNGEN UND LEITERBAHNANORDNUNG FÜR EINEN SOLCHEN SCHREIBKOPF.**

(30) Priorität : **14.12.88 EP 88120855**

(43) Veröffentlichungstag der Anmeldung :
**02.10.91 Patentblatt 91/40**

(45) Bekanntmachung des Hinweises auf die
Patenterteilung :
**09.06.93 Patentblatt 93/23**

(84) Benannte Vertragsstaaten :
**DE**

(56) Entgegenhaltungen :
**US-A- 4 612 554
PATENT ABSTRACTS OF JAPAN, vol. 10, no.
146 (M-482)(2203) 28 Mai 1986; JP A 61 002 575
(SATOU YOSHIHIKO) 08.01.1986
PATENT ABSTRACTS OF JAPAN, vol. 10, no.
21 (M-449)(2078) 28 Januar 1986; JP A 60 180
857 (NISHIGUSHI YASUO) 14.09.1985**

(56) Entgegenhaltungen :
**PATENT ABSTRACTS OF JAPAN, vol. 10, no.
21 (M-449)(2078) 28 Januar 1986;JP A 60 180
858 (NISHIGUSHI YASUO) 14.09.1985
PATENT ABSTRACTS OF JAPAN, vol. 10, no.
21 (M-449)(2078) 28 Januar 1986; JP A 60 180
855 (NISHIGUSHI YASUO) 14.09.1985
PATENT ABSTRACTS OF JAPAN, vol. 9, no.
215 (M-409)(1938) 03 September 1985; JP A 60
076 355 (SATOU YOSHIHIKO) 30.04.1985**

(73) Patentinhaber : **SIEMENS
AKTIENGESELLSCHAFT
Wittelsbacherplatz 2
W-8000 München 2 (DE)**

(72) Erfinder : **KAPPEL, Andreas
Fallstrasse 42
W-8000 München 70 (DE)**

(74) Vertreter : **Meissner, Peter E., Dipl.-Ing. et al
Meissner & Meissner, Patentanwaltsbüro,
Hohenzollerndamm 89
W-1000 Berlin 33 (DE)**

EP 0 448 614 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Verfahren zur Optimierung einer Leiterbahnanordnung für einen Schreibkopf in Tintendruckeinrichtungen und Leiterbahnanordnung für einen solchen Schreibkopf

Die Erfindung betrifft ein Verfahren zur Optimierung einer Leiterbahnanordnung für einen Schreibkopf in Tintendruckeinrichtungen sowie eine Leiterbahnanordnung für einen solchen Schreibkopf gemäß den Oberbegriffen der Patentansprüche 1 und 2.

In hochauflösenden Tintendruckeinrichtungen nach dem Bubble-Jet Prinzip muß die Gleichheit der Heizwiderstände wie auch der Zuleitungswiderstände sichergestellt sein. Andernfalls differieren die von verschiedenen Heizelementen eines Kopfes erzeugten Wärmemengen unter Umständen so stark, daß einige Heizelemente überlastet werden. Dies kann zu einer Reduktion der Kopflebensdauer oder auch zu einer Herabsetzung der maximalen Betriebsfrequenz durch unkontrollierte Verdampfungsvorgänge in der Tinte führen. Bei den bekannten Dünnfilm-Layouts für solche Schreibköpfe weist jedes einzelne Heizelement eine eigene elektrische Hin- und Rückleitung in Form von metallischen Leiterbahnen, vorzugsweise aus Aluminium auf, die zwecks externer elektrischer Kontaktierung beispielsweise an Einzelleiter eines Anschlußkabels über die Fläche des Dünnfilmsubstrats verteilt zu einem Anschlußfeld führen.

Der elektrische Widerstand der Zuleitungen (Hin- und Rückleitung) eines Heizelementes ist mit üblicherweise ca. $RZ = 20\Omega$ gegenüber dem Widerstand des Heizelementes selbst ($RH \approx 80\Omega$) nicht mehr vernachlässigbar.

Da die Heizelemente in einem randnahen Bereich des Dünnfilmsubstrats in einer Reihe mit enger Teilung angeordnet sind, und die Zuleitungen zwecks Kantaktierung zu dem relativ breiten Anschlußfeld auf der gegenüberliegenden Seite des Dünnfilmsubstrats geführt werden müssen, ergeben sich aufgrund der unterschiedlichen Leiterlängen auch unterschiedliche Zuleitungswiderstände für die einzelnen Heizelemente, was zu obengenannten Problemen führt.

Aus den JP-A-61 2575 und JP-A-60 76 355 sind Leiterbahnanordnungen für den individuellen Anschluß von Heizelementen bekannt, wobei die Anschlußleitungen ausgehend von den zu kontaktierenden Heizelementen in einen Bereich mit weiter Teilung, in einen an einem Anschluß einer integrierten Schaltung angrenzenden Bereich mit enger Teilung und einen diese beiden Bereiche verbindenden Übergangsbereich aufgegliedert sind. Die Anschlußleitungen in den einzelnen Bereichen verlaufen parallel zueinander und zur Erzielung eines annähernd gleichen Zuleitungswiderstandes der einzelnen Anschlußleitungen wird entweder nur an einer Seite (JP-A-6076355) der zu kantaktierenden Heizelemente oder beiderseits (JP-A-612575) der Heizelemente Widerstandskorrekturzonen vorgesehen. Die Korrekturzonen bzw. Leitungswiderstands-Kompensationsstrecken sind dabei durch unterschiedlich breite und lange Abschnitte der Anschlußleitungen allein in den Bereichen der weiten Teilung vorgesehen.

Die der Erfindung zugrundeliegende Aufgabe besteht deshalb darin, ein Verfahren zur Optimierung einer Leiterbahnanordnung für in Dünnschichttechnik aufgebaute Schreibköpfe in Tintendruckeinrichtungen anzugeben, das bei hochauflösenden Schreibköpfen einen für alle Heizelemente möglichst identischen und niedrigen Zuleitungswiderstand gewährleistet.

Diese Aufgabe wird gemäß mit den im kennzeichnenden Teil des Patentanspruches 1 angegebenen Mitteln gelöst. Eine vorteilhafte Anordnung sowie weitere Ausgestaltungen sind in den Ansprüchen 2-4 gekennzeichnet.

Durch eine geeignete Dimensionierung der Übergangsstruktur, welche die Leiterbahnen enger Teilung im Bereich der Heizelemente mit den Leiterbahnen weiter Teilung im Bereich der Anschlußkontakte miteinander verbindet, läßt sich ein für alle Heizelemente gleicher und niedriger Zuleitungswiderstand der Leiterbahnen realisieren. Eine Dimensionierungsvorschrift ordnet dabei den vorgegebenen Eingangsgrößen (Leiterbreiten und Spaltbreite der Leiterbahnen in den beiden Bereichen) und der Spaltbreite in der Übergangsstruktur die Leiterbreite in der Übergangsstruktur als Ausgangsgröße zu.

Die Erfindung wird im folgenden anhand eines Ausführungsbeispieles näher erläutert, wozu auf die Zeichnungen verwiesen wird.

Dort zeigen

Figur 1 eine Leiterbahnanordnung eines Bubble-Jet-Tintendruckkopfes mit je einem Hin- und Rückleiter pro Heizelement,

Figur 2 einen vergrößerten Ausschnitt der Leiterführung gemäß Figur 1,

Figur 3 den Verlauf der Spaltbreite in Abhängigkeit der Leiterdicke in der Übergangsstruktur und

Figur 4 und 5 funktionale Zusammenhänge zwischen dem Gesamtzuleitungswiderstand und den Leiterbahnbreiten für zwei Druckköpfe mit verschiedener Auflösung.

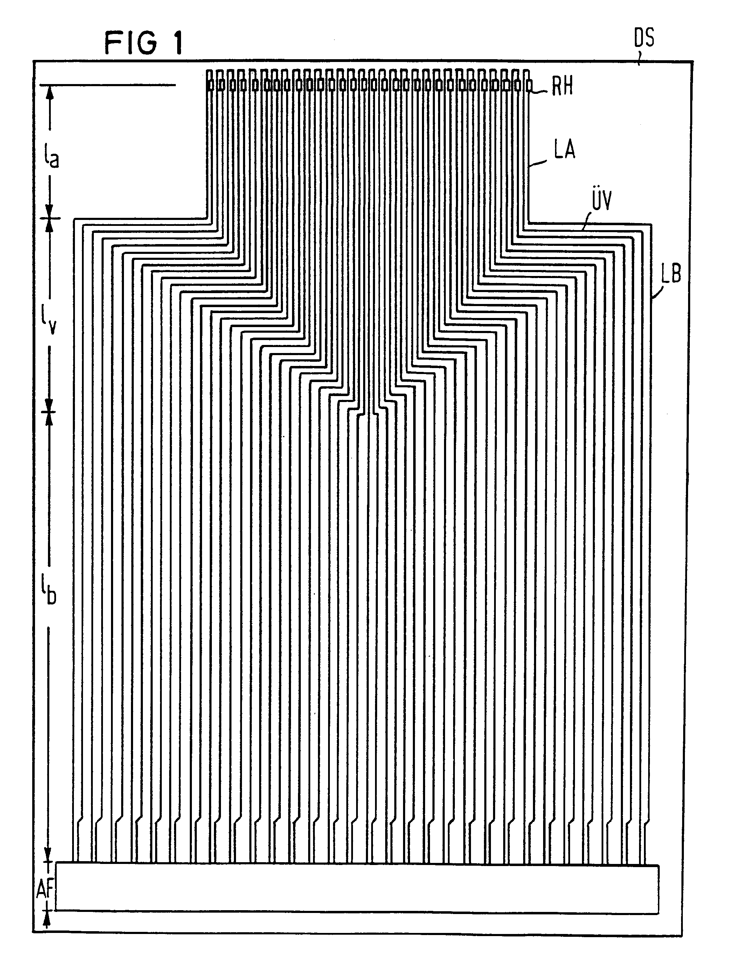

Bei dem in Figur 1 nur schematisch dargestellten Leiterbahn-Layout für einen Tintendruckkopf mit 30 Heizelementen ist mit dem Bezugszeichen DS ein Dünnfilmsubstrat bezeichnet, auf dem die einzelnen Heizelemente RH und ihre Zuleitungen strukturiert sind. Diese Zuleitungen -je eine Hin- und Rückleitung pro Heizelement- führen von den in einem Randbereich des Dünnfilmsubstrates DS gelegenen Heizelementen RH zu einem auf der gegenüberliegenden Seite des Dünnfilmsubstrates DS befindlichen Anschlußfeld AF, wo die Zuleitungen an ein hier nicht dargestelltes Anschlußkabel kontaktiert werden. Da einerseits für diese Kontaktierung ein ausreichender Platz zur Verfügung stehen muß und andererseits die Heizelemente RH aufgrund eines möglichst hohen Auflösungsvermögens relativ klein und dicht benachbart angeordnet sein sollen, sind die Leiterbahnen auf dem Dünnfilmsubstrat DS aufgefächert. Hierzu sind die Leiterbahnen auf dem Dünnfilmsubstrat DS im Bereich der Heizelemente RH in Leiterbahnen enger Teilung LA und im Bereich des Anschlußfeldes AF in Leiterbahnen weiter Teilung LB aufgegliedert. Eine Übergangsstruktur ÜV verbindet die Leiterbahnen enger Teilung LA mit den Leiterbahnen weiter Teilung LB. Die Längen dieser drei Bereiche sind ebenfalls in der Figur 1 eingezeichnet, wobei mit $1_A$ die Leitrlänge enger Teilung, mit $1_V$ die Länge der Übergangsstruktur und $1_B$ die Leiterlänge weiter Teilung gekennzeichnet ist.

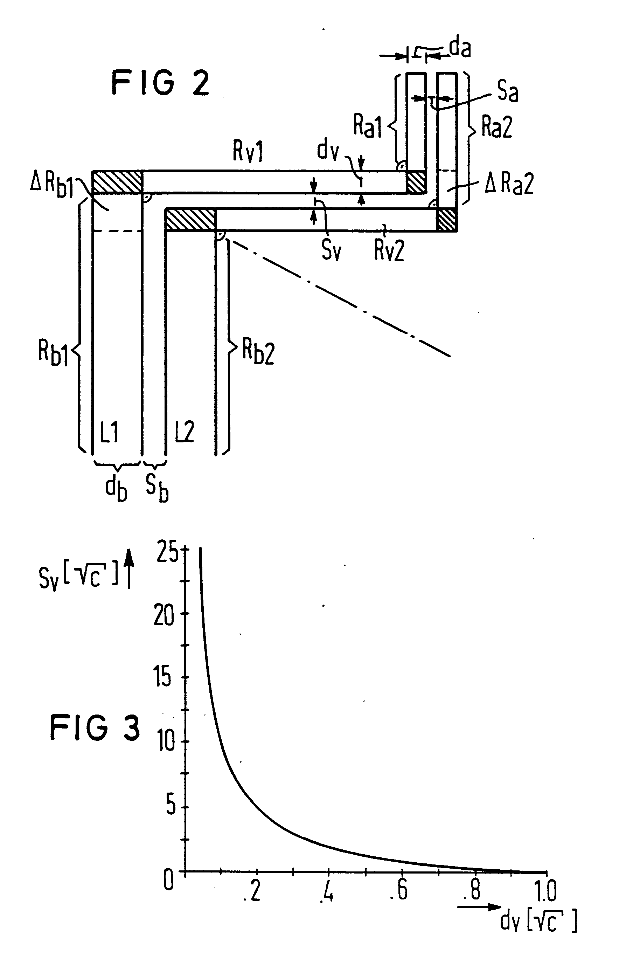

Durch geeignete Dimensionierung dieser Übergangsstruktur ÜV, welche die Leiterbahnen enger Teilung (im Bereich der Heizelemente) mit den Leiterbahnen weiter Teilung (im Bereich des Anschlußfeldes) verbindet, läßt sich ein gleicher und dabei dennoch kleiner Zuleitungswiderstand für alle Heizdots realisieren. Hierzu wird auf Figur 2 verwiesen, die einen vergrößerten Ausschnitt aus Figur 1 darstellt und den Verlauf zweier benachbarter Leiterbahnen L1,L2 in den genannten drei Bereichen zeigt.

In der Figur 2 sind die geometrischen Abmessungen sowie die Widerstandsbeiträge der einzelnen Leiterbahnabschnitte eingezeichnet. Es sind dies im einzelnen die Breite $d_a$, $d_v$ und $d_b$ der leiterbahnen in den Bereichen enger Teilung LA, der Übergangsstruktur ÜV und weiter Teilung LB sowie die Abstände $s_a$, $s_v$, $s_b$ zweier benachbarter Leiterbahnen L1,L2 in den entsprechenden Bereichen. Die Leiterbahnen innerhalb der einzelnen Bereiche verlaufen dabei parallel zueinander, während die Leiterbahnen jeweils benachbarter Bereiche rechtwinklig zueinander angeordnet sind.

Die Optimierung besteht nun darin, die Übergangsstruktur ÜV ($d_v$, $s_v$), welche die Leiterbahnen enger Teilung LA ($d_a$, $s_a$) mit den Leiterbahnen weiter Teilung LB ($d_b$, $s_b$) verbindet, so zu dimensionieren, daß die elektrischen Widerstände aller Zuleitungen gleich und dabei möglichst klein werden.

Aufgrund der Symmetrie der in Figur 2 gezeigten Struktur genügt es, einen funktionalen Zusammenhang zwischen Leiterbahnabstand $s_v$ und Leiterbahnbreite $d_v$ zu finden derart, daß die Leitungswiderstände zweier benachbarter Leiterbahnen L1, L2 gleich groß sind, d.h. $R_i = R_{i+1}$.

Die in Figur 2 schraffierten Eckbereiche werden dabei nicht berücksichtigt, da sie für alle Leiterbahnen betragsmäßig gleich groß sind. Unter Zugrundelegung der Bezeichnungen, wie sie in Figur 2 eingetragen sind, setzt sich der Gesamtwiderstand einer Leiterbahn $L_i$ aus einem Widerstandsanteil $R_{bi}$ der Leiterbahn weiter Teilung, aus einem Widerstandsanteil $R_{vi}$ der Übergangsstruktur und einem Widerstandsanteil $R_{ai}$ der Leiterbahn enger Teilung zusammen. Mit der Forderung, daß zwei benachbarte Leiterbahnen identischen Widerstand aufweisen sollen, d.h.

$$O = R_i - R_{i+1}$$

und mit $R_i = R_{bi} + R_{vi} + R_{ai}$
ergeben sich für die Leiterbahnen L1 und L2 folgende Gesetzmäßigkeiten

$$O = R_1 - R_2 \quad (1)$$
$$R_1 = R_{b1} + R_{v1} + R_{a1} \quad (2)$$
$$R_2 = R_{b2} + R_{v2} + R_{a2} \quad (3)$$
$$R_{b1} = R_{b2} + \Delta R_{b1} \quad (4)$$
$$R_{a2} = R_{a1} + \Delta R_{a2} \quad (5)$$

Durch Einsetzen der Gleichungen (2) bis (4) in die Gleichung (1) ergibt sich

$$O = \Delta R_{b1} + R_{v1} - R_{v2} - \Delta R_{a2} \quad (1')$$

Wird mit $\rho$ der spezifische Widerstand der Leiterbahnen und mit h die Leiterbahndicke bezeichnet, so folgt für die einzelnen Widerstandsbeiträge

$$\Delta R_{b1} = (\rho/h) \cdot ((d_v + s_v)/d_b))$$
$$\Delta R_{a2} = (\rho/h) \cdot ((d_v + s_v)/d_a))$$
$$R_{v1} - R_{v2} = (\rho/h) \cdot ((d_b + s_b - d_a - s_a)/d_v)$$

Setzt man diese drei Gleichungen in die Gleichung (1') ein, so erhält man nach mathematischem Umfarmen eine Beziehung für den Abstand $s_v$ der benachbarten Leiterbahnen L1, L2 im Übergangsbereich

$$s_v = d_b \cdot d_a \cdot (d_b + s_b - d_a - s_a)/(d_v \cdot (d_b - d_a)) - d_v$$

Dieser Abstand $s_v$ ist eine Funktion der vorgegebenen Parameter Abstände $s_a$, $s_b$ und Leiterbahnbreiten $d_a$, $d_b$ der Leiterbahnen in den Bereichen enger und weiter Teilung sowie des Parameters Leiterbahnbreite $d_v$ im Übergangsbereich. Mit der Abkürzung

$$c = d_b \cdot d_a \cdot (d_b + s_b - d_a - s_a)/(d_b - d_a)$$

ergibt sich für die Spaltbreite $s_v$ im Übergangsbereich die Beziehung

$$s_v = c/d_v - d_v \quad (*)$$

oder umgestellt nach der Leiterbreite $d_v$ im Übergangsbereich

$$d_v = -s_v/2 + \sqrt{s_v^2/4 + c}$$

In Figur 3 ist die Gleichung (*) in allgemeiner Form ($s_v$, $d_v$ in den Einheiten $\sqrt{c}$) dargestellt. Dabei ist auf der Abszisse die Leiterbahnbreite $d_v$ und auf der Ordinate die Spaltbreite $s_v$ aufgetragen.

Die Gleichung (*) besitzt eine Nullstelle bei $d_v = \sqrt{c}$, d.h. für Leiterbreiten der Übergangsstruktur ÜV mit $d_v > \sqrt{c}$ läßt sich keine Gleichheit der Zuleitungswiderstände erzielen, da in diesem Fall die Spaltbreite $s_v$ negativ wird ( bei $d_v = \sqrt{c}$ berühren sich die Übergangsleiterbahnen). Als Gesamtzuleitungswiderstand wird die Summe der Widerstände von Hin- und Rückleiter bezeichnet ($R_{ges} = 2\, R_g$). Der Widerstand einer Zuleitung $R_g$ setzt sich anteilmäßig aus den Widerstandsbeiträgen der Leiter enger Teilung LA, weiter Teilung LB und der Übergangsstruktur ÜV zusammen.

Bei Anwendung von Gleichung (*) gilt, da der elektrische Widerstand aller Leiter dieser Übergangsstruktur ÜV gleich groß ist:

$$R_v = (\rho/h) \cdot ((n_{max} - 1) \cdot (s_v + d_v)/d_a)$$

mit: $n_{max}$=halbe Leiteranzahl des Schreibkopfes (z.B. $n_{max}$=30 bei 30 Heizelementen).

Nach Figur 1 ergibt sich damit für den Gesamtwiderstand $R_g$ einer Zuleitung (Hin- oder Rückleitung):

$$R_g = R_a + R_v + R_b$$

$$= (\rho/h) \cdot (1_a/d_a + (n_{max} - 1) \cdot ((s_v + d_v)/d_a) + 1_b/d_b)$$

mit $1_b = 1_g - 1_a - ((n_{max} - 1) \cdot (s_v + d_v) + d_v)$
folgt für den Gesamtwiderstand einer Zuleitung

$$R_g = (\rho/h) \cdot (1_a/d_a + (n_{max} - 1) \cdot (1/d_a - 1/d_b) \cdot c/d_v + ((1_g - 1_a - d_v)/d_b), \quad 1_b \geqq 0 \quad (**)$$

Für einen Schreibkopf mit 30 Heizelementen und einer Auflösung von 180 dots per inch (dpi) mit folgenden äußeren Abmessungen des Dünnfilmsubstrates DS, wie er in Figur 1 dargestellt ist, bzw. den vargegebenen Eingangsgrößen

$$d_a = 50 \ \mu m, \qquad s_a = 20{,}5 \ \mu m$$
$$d_b = 100 \ \mu m, \qquad s_b = 30{,}0 \ \mu m$$
$$1_g = 8658 \ \mu m, \qquad 1_a = 1547{,}0 \ \mu m$$

ergeben sich unter Berücksichtigung des spezifischen Widerstandes dünner Aluminiumschichten $\rho_{Al}= 3 \cdot 10^8$ $\Omega$ m, wie sie für Leiterbahnen verwendet werden können und einer Leiterbahndicke h von 0,5 $\mu$m folgende, in der Tabelle 1 zusammengefaßten Werte für die Leiterbahnbreite $d_v$, Spaltbreite $s_v$ und Länge der Übergangsstruktur $1_v$ sowie der Gesamtwiderstand $R_g$

Tabelle 1

| $d_v$ ($\mu$m) | $s_v$ ($\mu$m) | $1_v$ (mm) | $R_g$ ($\Omega$) |
|---|---|---|---|
| 30,0 | 168,3 | 5,76 | 9,6 |
| 40,0 | 108,8 | 4,36 | 8,7 |
| 50,0 | 69,0 | 3,50 | 8,2 |
| 60,0 | 39,2 | 2,94 | 7,8 |
| 67,6 | 20,5 | 2,54 | 7,6 |
| 70,0 | 15,0 | 2,62 | 7,56 |

Als weiteres Beispiel diene ein Schreibkopf mit 300 dpi Auflösungsvermögen und 50 Heizelementen, dessen äußeren Abmessungen identisch den Abmessungen des oben beschriebenen Schreibkopfes (180 dpi) entsprechen.

Mit den Eingangsgrößen

$$d_a = 21,83 \ \mu m, \qquad s_a = 20,5 \ \mu m$$
$$d_b = 48,00 \ \mu m, \qquad s_b = 30,0 \ \mu m$$
$$l_g = 8658 \ \mu m, \qquad l_a = 1547 \ \mu m$$

$n_{max} = 50$
$Al = 3 \ 10^{-8} \ \Omega \ m$
$h = 0,5 \ \mu m$

ergeben sich für den 300 dpi Schreibkopf die in Tabelle 2 eingetragenen Werte.

Tabelle 2

| $d_v \ (\mu m)$ | $s_v \ (\mu m)$ | $l_v \ (mm)$ | $R_g \ (\Omega)$ |
|---|---|---|---|
| 10,0 | 132,8 | 7,01 | 23,6 |
| 15,0 | 80,2 | 4,68 | 20,1 |
| 20,0 | 51,4 | 3,52 | 18,4 |
| 25,0 | 32,1 | 2,82 | 17,3 |
| 28,9 | 20,5 | 2,45 | 16,7 |
| 30,0 | 17,6 | 2,36 | 16,6 |
| 35,0 | 5,8 | 2,03 | 16,1 |

Bei einer Spaltbreite $s_v = 20,5 \ \mu m$ beträgt damit der gesamte Zuleitungswiderstand pro Heizelement beim 180 dpi Schreibkopf $R_{ges} = 2 \cdot R_g = 15,2 \ \Omega$ und beim 300 dpi Schreibkopf $R_{ges} = 2 \cdot R_g = 33,4 \ \Omega$

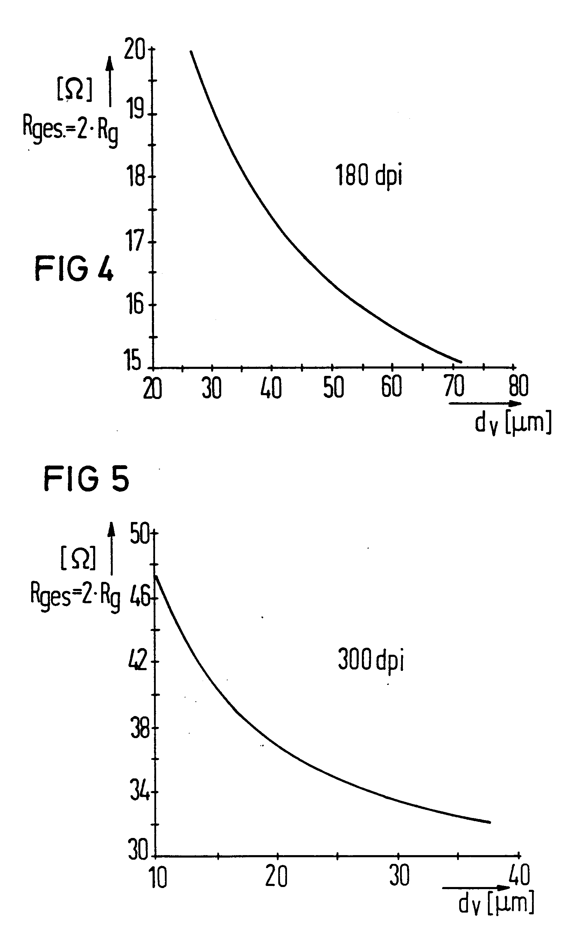

In den Figuren 4 und 5 sind für eine angenommene Aluminiumdicke von h=0,5 die Gesamtzuleitungswiderstände $R_{ges} = 2 \ R_g$ als Funktionen der Leiterbahnbreite $d_v$ der Übergangsstruktur ÜV einmal für einen 180 dpi Schreibkopf (Fig.4) und einmal für einen 300 dpi Schreibkopf (Fig. 5) dargestellt.

**Patentansprüche**

1. Verfahren zur Optimierung einer Leiterbahnanordnung für einen Schreibkopf in Tintendruckeinrichtungen, bei denen eine Mehrzahl von Heizelementen (RH) über Leiterbahnen (L$_i$) selektiv angesteuert werden und diese Leiterbahnen (L$_i$) auf einem Dünnfilmsubstrat (DS) verteilt zu einem Anschlußfeld (AF) führen, wobei die Leiterbahnen (L$_i$) in einen Bereich enger Teilung (LA) und in einen Bereich weiter Teilung (LB) aufgegliedert und mittels einer Übergangsstruktur (ÜV) verbunden sind, **dadurch gekennzeichnet,** daß aus den vargegebenen Strukturgrößen der beiden zu verbindenden Leiterbahnbereiche, nämlich den Leiterbahnbreiten ($d_a, d_b$) und Spaltbreiten ($S_a, S_b$) sowie aus der Spaltbreite ($S_v$) in der Übergangsstruktur (ÜV) die Leiterbahnbreite ($d_v$) in der Übergangsstruktur (ÜV) nach folgender Beziehung

$$d_v = -s_v/2 + \sqrt{s_v^2/4 + c}$$

mit

$$c = d_b \cdot d_a \cdot (d_b + s_b - d_a - s_a)/(d_b - d_a)$$

dimensioniert wird, so daß alle Leiterbahnen (L$_i$) für die verschiedenen Heizelemente (RH) etwa denselben Zuleitungswiderstand aufweisen.

2. Leiterbahnanordnung für einen Schreibkopf in Tintendruckeinrichtungen, bei denen eine Mehrzahl von Heizelementen (RH) über Leiterbahnen ($L_i$) selektiv angesteuert werden und diese Leiterbahnen ($L_i$) auf einem Dünnfilmsubstrat (DS) verteilt zu einem Anschlußfeld (AF) führen, wobei die Leiterbahnen ($L_i$) ausgehend von den zu kantaktierenden Heizelementen (RH) in einen Bereich mit Leiterbahnen enger Teilung (LA), einen am Anschlußfeld (AF) angrenzenden Bereich mit Leiterbahnen weiter Teilung (LB) und eine diese beiden Bereiche verbindende Übergangsstruktur (ÜV) aufgefächert sind, **dadurch gekennzeichnet**, daß die Breiten ($d_i$) der Leiterbahnen ($L_i$) und die Abstände (Spaltbreiten $s_i$) zwischen zwei benachbarten Leiterbahnen (L1,L2) innerhalb der jeweiligen Bereiche (LA,LB,ÜV) konstant und gegenüber den anderen Bereichen (LA,LB,ÜV) unterschiedlich bemessen sind, daß abhängig von den Leiterbahnbreiter ($d_a,d_b$) und den Spaltbreiten ($s_a,s_b$) der Leiterbahnen ($L_i$) in den Bereichen (LA,LB) sowie der Spaltbreite ($s_v$) in der Übergangsstruktur (ÜV) die Leiterbreite ($d_v$) in der Übergangsstruktur (ÜV) derart dimensioniert wird, daß alle Leiterbahnen etwa denselben Zuleitungswiderstand ($R_g$) aufweisen.

3.  Leiterbahnanordnung nach Anspruch 2, **dadurch gekennzeichnet**, daß die Leiterbahnen ($L_i$) innerhalb der einzelnen Bereiche (LA,LB,LV) parallel zueinander verlaufen.

4.  Leiterbahnanordnung nach Anspruch 2, **dadurch gekennzeichnet**, daß jeweils die Leiterbahen angrenzender Bereiche (LA, ÜV, LB) zueinander rechtwinklig angeordnet sind.

## Claims

1.  A method of optimizing a conductor path arrangement for a printer head in ink-jet printers in which a plurality of heating elements (RH) are selectively driven via conductor paths ($L_i$) and these conductor paths ($L_i$), distributed over a thin-film substrate (DS), lead to a Connection area (AF), wherein the conductor paths ($L_i$) are fanned out into a closely spaced zone (LA) and a widely spaced zone (LB) and are connected by means of a transition structure (UV), characterised in that on the basis of the predetermined structural sizes of the two conductor path zones which are to be connected, namely the conductor path widths ($d_a$, $d_b$) and gap widths ($S_a$, $S_b$) and on the basis of the gap width ($S_b$) in the transition structure (UV), the conductor path width ($d_v$) in the transition structure (UV) is dimensioned in accordance with the following equation

$$d_v = - s_v/2 + \sqrt{s_v^2/4 + c}$$

wherein

$$c = d_b \cdot d_a \cdot (d_b + s_b - d_a - s_a)/(d_b - d_a)$$

so that all the conductor paths ($L_i$) possess approximately the same supply line resistance for the different heating elements (RH).

2.  A conductor path arrangement for a printer head in ink-jet printers in which a plurality of heating elements (RH) are selectively driven via conductor paths ($L_i$) and these conductor paths ($L_1$), distributed over a thin-film substrate (DS), lead to a connection area (AF), wherein, commencing from the heating elements (RH) which are to be contacted, the conductor paths ($L_i$) are fanned out into a zone (LA) which comprises closely spaced conductor paths, a zone (LB) which comprises widely spaced conductor paths and which is adjacent to the connection area (AF), and a transition structure (UV) which connects these two zones, characerised in that the widths ($d_i$) of the conductor paths ($L_i$) and the intervals (gap widths $s_i$) between two adjacent conductor paths (L1, L2) within the respective zones (LA, LB, UV) are contrived to be constant and to differ in relation to the other zones (LA, LB, UV), that in dependence upon the conductor path widths ($d_a$, $d_b$) and the gap widths ($s_a$, $s_b$) of the conductor paths ($L_i$) in the zones (LA, LB) and the gap width ($S_v$) in the transition zone (UV), the conductor path width ($d_v$) in the transition structure (UV) is dimensioned such that all the conductor paths possess approximately the same supply line resistance ($R_g$).

3.  A conductor path arrangement as claimed in Claim 2, characterised in that the conductor paths ($L_i$) extend in parallel to one another within the individual zones (LA, LB, LV).

4.  A conductor path arrangement as claimed in Claim 2, characterised in that the respective conductor paths of adjacent zones (LA, UV, LB) are arranged at right angles to one another.

**Revendications**

1.  Procédé pour optimiser un dispositif de pistes conductrices pour une tête d'écriture dans des dispositifs d'impression à encre, dans lesquels une pluralité d'éléments de chauffage (RH) sont amorcés sélectivement par l'intermédiaire de pistes conductrices ($L_i$) et ces pistes conductrices ($L_i$) mènent séparément, sur un substrat à couche mince (DS), à un champ de raccord (AF), les pistes conductrices ($L_i$) étant divisées en une zone de séparation étroite (LA) et en une zone de séparation large (LB) reliées au moyen d'une structure de jonction (UV),
    caractérisé en ce que, à partir des tailles prédéfinies de structure des deux zones de pistes conductrices à relier, à savoir les largeurs de piste conductrice ($d_a$,$d_b$) et les largeurs d'espacement ($S_a$,$S_b$), ainsi qu'à partir de la largeur d'espacement ($S_v$) dans la structure de jonction (UV), la largeur de piste conductrice ($d_v$) dans la structure de jonction (UV) est définie par la relation suivante :

    $$d_v \; = \; - \; s_v/2 \; + \; \sqrt{s_v^2/4 \; + \; c}$$

    avec c = $d_b \cdot d_a \cdot$ ($d_b$+ $s_b$-$d_a$-$s_a$)/($d_b$-$d_a$)
    de sorte que toutes les pistes conductrices ($L_i$), présentent, pour les différents éléments de chauffage (RH), environ la même résistance.

2.  Dispositif de pistes conductrices pour une tête d'écriture dans des dispositifs d'impression à encre, dans lesquels une pluralité d'éléments de chauffage (RH) sont amorcés sélectivement par l'intermédiaire de pistes conductrices ($L_i$) et ces pistes conductrices ($L_i$) mènent séparément, sur un substrat à couche mince (DS), à un champ de raccord (AF), les pistes conductrices ($L_i$) s'étendant, à partir des éléments de chauffage (RH) à mettre en contact, dans une zone de séparation étroite (LA) des pistes conductrices, une zone de séparation large (LB) des pistes conductrices adjacente au champ de raccord (AF), et une structure de jonction (UV) reliant ces deux zones,
    caractérisé en ce que les largeurs ($d_i$) des pistes conductrices ($L_i$) et les écarts (largeurs d'espacement $S_i$) entre deux pistes conductrices voisines (L1,L2) à l'intérieur de chacune des zones (LA,LB,UV) sont constantes et différentes par rapport aux autres zones (LA,LB,UV), en ce que, en fonction des largeurs de piste conductrice ($d_a$,$d_b$) et des largeurs d'espacement ($S_a$,$S_b$) des pistes conductrices ($L_i$) dans les zones (LA,LB) ainsi que de la largeur d'espacement ($S_v$) dans la structure de jonction (UV), la largeur de piste conductrice ($d_v$) dans la structure de jonction (UV) est dimensionnée de sorte que toutes les pistes conductrices présentent environ la même résistance ($R_g$).

3.  Dispositif de pistes conductrices selon la revendication 2,
    caractérisé en ce que les pistes conductrices ($L_i$) s'étendent parallèlement les unes aux autres à l'intérieur des zones individuelles (LA,LB,UV).

4.  Dispositif de pistes conductrices selon la revendication 2,
    caractérisé en ce que, à chaque fois, les pistes conductrices de zones adjacentes (LA,UV,LB) sont agencées les unes par rapport aux autres à angle droit.

FIG 1

FIG 2

FIG 3

FIG 4

FIG 5